# EUROPEAN PATENT APPLICATION

(11) **EP 2 562 813 A2**
(43) Date of publication of application: **27.02.2013**
(21) Application number: 12006023.1
(22) Date of filing: 23.08.2012
(51) Int. Cl.: H01L 27/15, F21S 8/10, H01L 33/00, H01L 33/38, H01L 33/62, F21Y 101/02

(54) **LED array capable of reducing uneven brightness distribution**

(30) Priority: 23.08.2011 JP 2011181449; 02.09.2011 JP 2011191646
(71) Applicant: Stanley Electric Co., Ltd., Tokyo (JP)
(72) Inventor: Miyachi, Mamoru, Tokyo (JP); Saito, Tatsuma, Tokyo (JP)
(74) Representative: Carstens, Dirk Wilhelm

(57) **Abstract**

A semiconductor LED array (100) comprises a plurality of semiconductor LED elements (101a, 101b) disposed on an oblong substrate that is long in a first direction (W) and arranged along with said first direction (W). Each LED element comprises an electrode layer (12) formed on the substrate (30), a semiconductor LED stack (2) formed on the electrode layer, stretched long in the first direction and comprising a p-type semiconductor layer (23), an active layer (22) and an n-type semiconductor layer (21), a first wiring layer (11) formed along and in parallel to one long side of the semiconductor LED stack, and second wiring layers (8) extending to a direction of a short side (H) from the first wiring layer and electrically connected to the n-type semiconductor layer (21) on a surface of the semiconductor LED stack. The first wiring layers are disposed on different long sides of the semiconductor LED stacks (2) in the adjacent LED elements.

## Description

### BACKGROUND OF THE INVENTION

### A) FIELD OF THE INVENTION

This invention relates to a semiconductor light emitting element array and an automotive lighting using the semiconductor light emitting element arrays.

### B) DESCRIPTION OF THE RELATED ART

High power is required for a light emitting diode (LED) element for use in headlamps for vehicles, illuminations or the likes. If a size of the element is simply enlarged, a driving electric current becomes too large and it becomes difficult to flow an electric current uniformly in the element. Therefore, in order to obtain a high power LED, a plurality of LED elements are arranged in a series to form an LED array (for example, refer to Japanese Laid-open Patent Publication No. 2001-156331).

In application of headlamps for vehicles or the likes, an oblong LED array is required. However, increase in the number of LED elements is not preferable because a proportion of non-light-emitting regions between the elements increases. Thus a shape of each LED element in an LED array becomes an oblong.

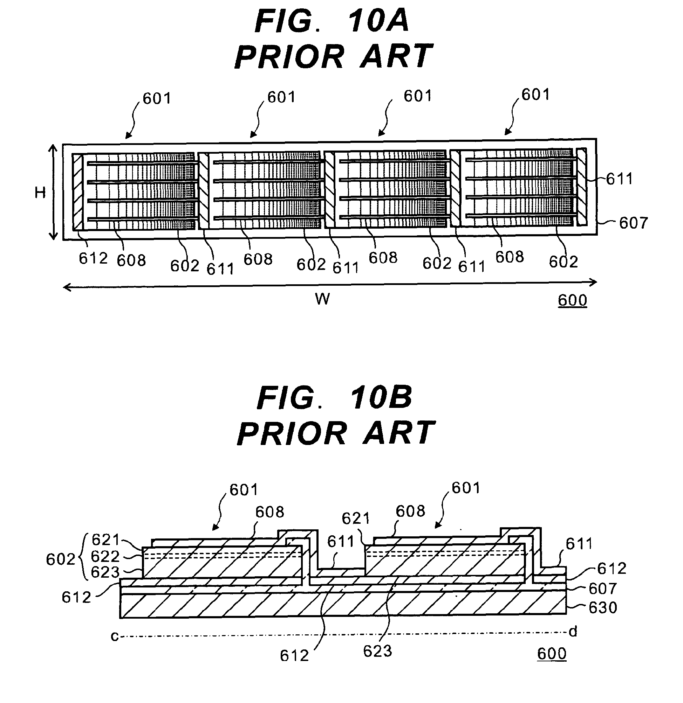

Fig. 10A is a schematic plan view showing a conventional LED array 600, and Fig. 10B is a simplified cross sectional view of the LED array 600 shown in Fig. 10A.

Generally the conventional LED array 600 has four nitride semiconductor light emitting elements arranged and connected in a series on an insulating supporting substrate. In case of GaN-based white LED element, LED structures are formed on a sapphire substrate, a supporting substrate is adhered, the sapphire substrate is separated, and electrodes are formed.

Each LED element 601 has a GaN-based light emitting part 602 consisting of an n-type GaN layer 621, an active layer 622 and a p-type GaN layer 623, a p-electrode 612 formed on a back surface of the light emitting part 602, a wiring electrode (first wiring layer) 611 arranged on a right short side of the light emitting part 602 with a predetermined interval in parallel to the short side, and wiring electrodes (second wiring layers) 608 arranged on a surface of the light emitting part 602 in parallel to a long side of the light emitting part 602 and connecting the n-type GaN layer 621 with the wiring electrodes 611. The LED elements 601 adjacent horizontally (in a longitudinal direction of the LED elements 601) are connected with each other by forming the wiring electrode 611 of one (left-side) LED element 601 on the p-electrode 612 of the adjacent (right-side) LED element 601 in order to connect the n-type GaN layer 621 of the left-side element with the p-type GaN layer 623 of the right-side element. Moreover, hatching of the light emitting part 602 in Fig. 10A indicates brightness distribution wherein increase in density of hatching indicates increase in brightness.

When the wiring electrode 611 is arranged in parallel to the short side of the LED element 601 and the wiring electrodes 608 on the n-type GaN layer 621 are arranged in parallel to the long side of the LED element 601, a length of the wiring electrode 608, for example, with a width of about 10µm becomes long and its wiring resistance becomes large. Therefore, an injection current decreases from the right power supply side to the left side and it generates uneven brightness distribution.

Moreover, because the wiring electrode 611 with a width of about 40µm is disposed between the LED elements 601, the interval between the LED elements 601 becomes wide and the brightness decreases; therefore, uneven brightness distribution is generated between the central and the peripheral areas of the element. If a headlamp or the likes is manufactured with the LED array 600 consisting of the above-described conventional LED elements 601, the uneven brightness is generated in a projection image.

### SUMMARY OF THE INVENTION

It is an object of the present invention to provide a semiconductor light emitting element array capable of reducing uneven brightness distribution.

It is another object of the present invention to provide an automotive lighting capable of reducing uneven brightness in a projection image.

According to one aspect of the present invention, there is provided a semiconductor light emitting array wherein a plurality of semiconductor light emitting elements are disposed on an oblong substrate that is long in a first direction and the semiconductor light emitting elements are arranged along with the first direction, each one of the light emitting elements comprising: an electrode layer formed on the substrate; a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer; a first wiring layer formed along and in parallel to one long side of the semiconductor light emitting layer; and second wiring layers extending to a direction of a short side from the first wiring layer and electrically connected to the n-type semiconductor layer on a surface of the semiconductor light emitting layer, wherein the first wiring layers are disposed on different long sides of the semiconductor light emitting layers in the adjacent light emitting elements.

According to another aspect of the present invention, there is provided a semiconductor light emitting array wherein a plurality of semiconductor light emitting elements are disposed on a substrate, each one of the light emitting elements comprising: an electrode layer formed on the substrate; a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer; a first wiring layer formed along and in parallel to one side of the semiconductor light emitting layer; and second wiring layers extending to the semiconductor light emitting layer from the first wiring layer and electrically connected to the n-type semiconductor layer on a surface of the semiconductor light emitting layer, wherein an amount of an injection current to the semiconductor light emitting layer by the second wiring layer formed around an edge of the semiconductor light emitting layer near the adjacent light emitting element is larger than an amount of an injection current to the semiconductor light emitting layer by the second wiring layer formed around a center of the semiconductor light emitting layer.

According to a further aspect of the present invention, there is provided an automotive lighting, comprising: at least two of the above described semiconductor light emitting arrays; and an optical system that projects projection images of said at least two semiconductor light emitting arrays with overlapping each other on a projection plane, wherein said at least two semiconductor light emitting arrays are arranged to make brightness distribution of the projection image of one semiconductor light emitting array a mirrored image of brightness distribution of the projection image of another semiconductor light emitting array.

According to the present invention, there is provided a semiconductor light emitting element array capable of reducing uneven brightness distribution.

Moreover, according to the present invention, there is provided an automotive lighting capable of reducing uneven brightness in a projection image.

### BRIEF DESCRIPTION OF THE DRAWINGS

Fig. 1A to Fig. 1D are schematic plan views, circuit diagram and cross sectional view of an LED array 100 and LED elements 101 according to a first embodiment of the present invention.
Fig. 2A and Fig. 2B are diagrams showing structures of automotive lightings (headlamps) 50 equipped with the LED arrays 100 according to the embodiment of the present invention.
Fig. 3A to Fig. 3F are schematic cross sectional views for explaining one manufacturing method of the LED array 100 according to the first embodiment of the present invention.
Fig. 4A to Fig. 4D are schematic cross sectional views for explaining one manufacturing method of the LED array 100 according to the first embodiment of the present invention.
Fig. 5 is a schematic cross sectional view for explaining another manufacturing method of the LED array 100 according to the first embodiment of the present invention.
Fig. 6 is a graph showing brightness distribution of the LED array 100 according to the first embodiment of the present invention.
Fig. 7A and Fig. 7B are schematic plan views of an LED array 200 and LED elements 201 according to a second embodiment of the present invention.
Fig. 8 is a schematic cross sectional views of an LED element 401 according to first modified example of the second embodiment of the present invention.
Fig. 9A and Fig. 9B are schematic plan views of an LED array 300 and LED elements 301 according to a third embodiment of the present invention.
Fig. 10A and Fig. 10B are a schematic plan view and a simplified cross sectional view of an LED array 600 according to the prior art.

### DESCRIPTION OF THE PREFERRED EMBODIMENTS

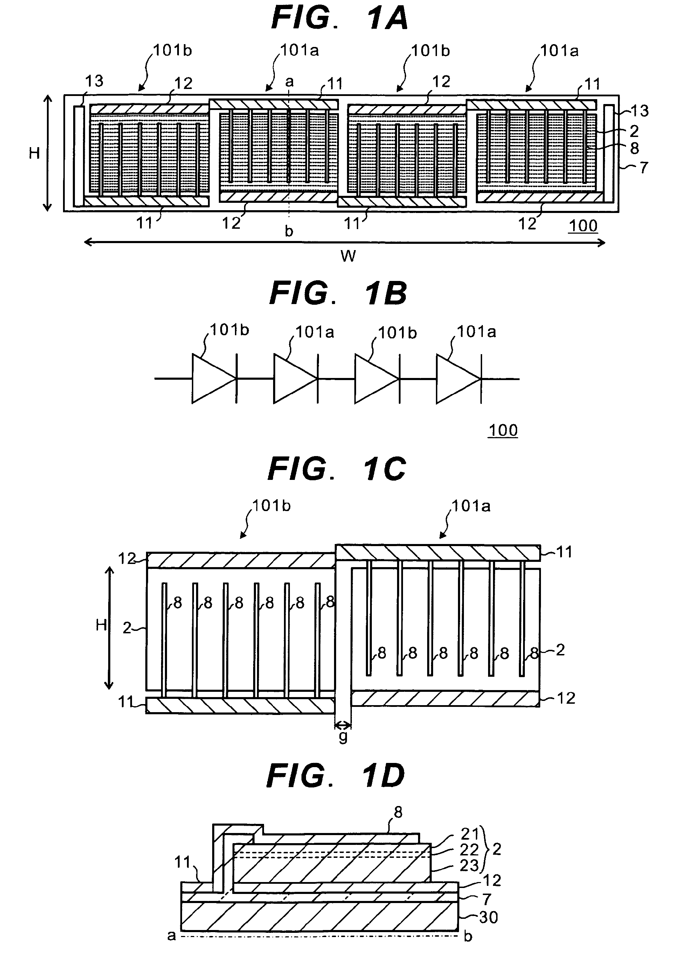

Fig. 1A is a schematic plan view of an LED array 100 according to a first embodiment of the present invention, and Fig. 1B is a circuit diagram of the LED array 100. Fig 1C is a schematic plan view of LED elements 101a and 101b composing the LED array 100. Fig. 1D is a simplified cross sectional view of the LED array 100 cut along a line a-b in Fig. 1A. Moreover, hatching of the light emitting part 2 in Fig. 1A indicates brightness distribution wherein increase in density of hatching indicates increase in brightness.

The LED array 100 according to the first embodiment of the present invention is an array of four nitride semiconductor light emitting elements (LED elements) 101 (101a and 101b) connected in series and arranged along a W direction in the drawing on a supporting substrate 30 which is long in the W direction and on which an insulating layer 7 is formed. Each one of the LED elements 101 is an oblong which is long in the W direction and consists of a GaN-based light emitting part (device structure layer) 2 including an n-type GaN layer 21, an active layer 22 and a p-type GaN layer 23, a p-electrode 12 formed on a back surface of the light emitting part 2 and exposed (or projecting) from one of top and bottom long sides of the light emitting part 2, a wiring electrode (first wiring layer) 11 disposed in parallel to the long side at a position with a predetermined interval from another long side of the light emitting part 2, which is opposite from the one side where the p-electrode 12 is exposed, and wiring electrodes (second wiring layers) 8 disposed on a surface of the light emitting part 2 in parallel to a short side of the light emitting part 2 and connecting the n-type GaN layer 21 and the wiring electrode 11.

Each LED element 101 is electrically connected in series to the LED elements 101 adjacent to its left and right. The wiring electrode 11 of the LED element 101a is electrically connected to the p-electrode 12 of the LED element 101b on the left, and the p-electrode 12 of the LED element 101a is electrically connected to the wiring electrode 11 of the LED element 101b on the right. The p-electrode 12 of the LED element 101a at the end and the wiring electrode 11 of the LED element 101b at the end are electrically connected to power supply pads 13 respectively.

Regarding the LED element 101a, an injection current gradually decreases from the top to the bottom of the drawing because the wiring electrode 11, the power supply side, is disposed on the upper long side of the light emitting part 2 in parallel to the upper long side, and the wiring electrodes 8 extend from the wiring electrode 11 to the n-type GaN layer 21 in parallel to the short side of the light emitting part 2. Therefore, the LED element 101a has a brightness distribution wherein the upper side is bright and the lower side is dark. However, because a length of each wiring electrode 8 becomes shorter than that in the prior art shown in Fig. 10 by arranging the wiring electrodes 8 in parallel to the short side of the light emitting part 2, decrease in the injection current and unevenness in the brightness distribution can be reduced.

That is, on a light emitting surface of the LED element 101a is formed a brightness distribution that has a peak (the maximum brightness point) near the wiring electrode 11 and wherein the brightness gradually decreases as it goes further from the wiring electrode 11 downward (to a direction H) in the drawing.

Although the similar brightness distribution is formed on the light emitting surface of the LED element 101b as the LED element 101a, the wiring electrode 11 is formed along the lower long side of the LED element 101b. Therefore, contrary to the light emitting surface of the LED element 101a, the light emitting surface of the LED element 101b has the brightness distribution that has a peak (the maximum brightness point) near the lower long side and wherein the brightness gradually decreases as it goes upward in the drawing. Moreover, the LED element 101a and the LED element 101b basically has the same structures except the electrode patterns such as positions of the p-electrodes 12, wiring electrodes 11 and the wiring electrodes 8. The electrode pattern of the LED element 101b is upside-down of that of the LED element 101a.

High power is required for LED elements to be used in headlamps of vehicles or illuminations. If simply a size of the element is enlarged, a driving voltage increases and it becomes difficult to flow an electric current uniformly. Therefore, in the first embodiment, a plurality of the LED elements 101 are arrayed to form the LED array 100. It is preferable to connect the LED elements 101 in series for flowing the same electric current in all the LED elements 101.

Moreover, in case of using the LED array in a headlamp of a vehicle, it is required to illuminate near the ground surface, and so it is preferable to shape the LED array 100 in an oblong that is long in a horizontal direction (a direction W in the drawing). A size of the LED array 100 is, for example, 5mm or more in width and 1mm or less in height. In case of arraying four LED elements 101, it is efficient to use LED elements each of which is an oblong that is long in a horizontal direction and short in a vertical direction (long in the direction W and short in the direction H).

Furthermore, when the narrow wiring electrodes 608 with a width of about 10µm are disposed on the light emitting surface of the horizontal oblong LED element 101 in parallel to the long side as shown in Fig. 10, a ratio of wiring resistance of the narrow wiring electrodes 608 (e.g., with a width of 10µm) to the resistance of the semiconductor layer (light emitting part) becomes large, an unevenness of the electric current distribution in the semiconductor layer 602 becomes large and so the brightness distribution becomes considerably uneven.

Thus, according to the embodiment, the electrode structure (electrode pattern) as shown in Fig. 1A and Fig. 1C is adopted, wherein a wide wiring electrode (first wiring layer) 11 with a width of 20µm to 200µm (preferably about 40µm) is disposed in parallel to the long side of each LED element 101, and the narrow wiring electrodes (second wiring electrodes) 8 are disposed in parallel to the short side for reducing the unevenness of the electric current distribution by reducing the length of the electrodes. With this electrode pattern, the wiring resistance is reduced by shortening the length of the wiring electrodes 8, and the unevenness of the brightness distribution in each LED element 101 can be significantly reduced.

Although unevenness of the brightness distribution in each LED element 101 and the brightness distribution in the LED array 100 caused by the decrease in the brightness around the intervals between LED elements 101 can be significantly reduced by adopting the electrode pattern according to the embodiment, unevenness of the brightness distribution is still found in a projection image of a headlamp or the likes that uses the LED array 100 if the plurality of the LED elements 101 are simply arrayed to form the array. In order to further reduce the unevenness of the brightness distribution, according to the first embodiment, as shown in Fig. 1A, the brightness distributions of adjacent LED elements 101 are alternatively changed, for example, alternatively upside down as shown in the drawing.

That is, the LED elements 101a and LED elements 101b are alternatively disposed along the long side of the LED array 100. Each LED element 101a has the wiring electrode (first wiring layer) 11 disposed along one long side of the light emitting part 2 (the lower long side in Fig. 1A and Fig. 1C) and the wiring electrodes (second wiring layer) 8 extending from the one long side to vicinity of another long side, whereas each LED element 101b has the wiring electrode (first wiring layer) 11 disposed along the another long side of the light emitting part 2 (the upper long side in Fig. 1A and Fig. 1C) and the wiring electrodes (second wiring layer) 8 extending from the another long side to vicinity of the one long side.

By alternatively disposing the LED elements 101a and 101b as in the above, the adjacent LED elements 101a and 101b have upside-down brightness distributions to reduce the uneven brightness distribution in the LED array 100 as a whole.

Moreover, because the wiring electrode 11 is disposed along the long side of the LED element 101, comparing to the prior art disposing it along the short side, the interval g between the LED elements can be narrow, for example, around 30µm. Therefore, the decrease in brightness in a region near the interval between the LED elements 101 can be further restrained.

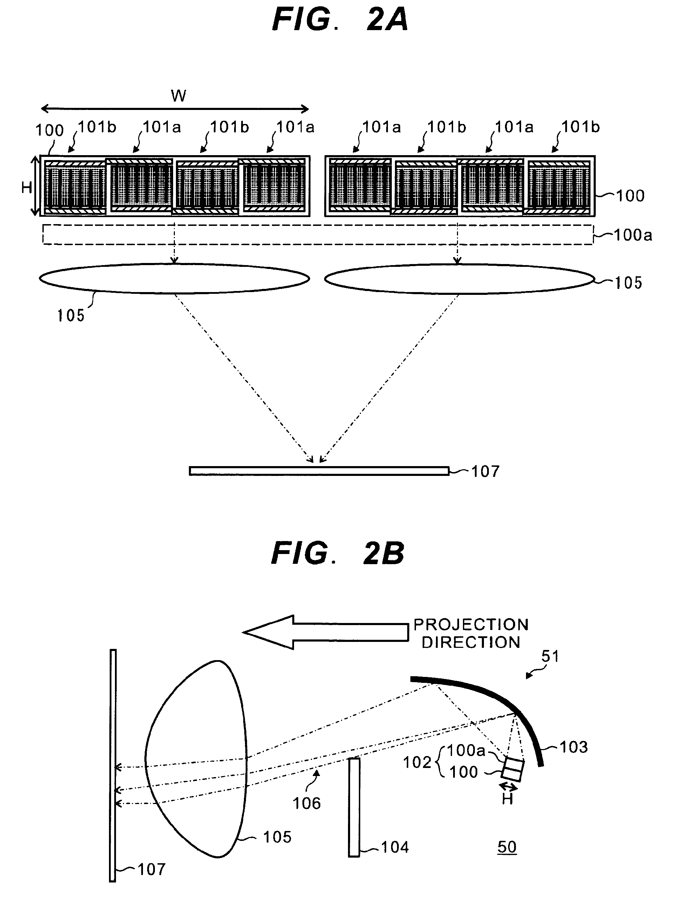

Fig. 2A and Fig. 2B are diagrams showing structures of automotive lightings (headlamps) 50 equipped with the LED arrays 100 according to the first embodiment of the present invention. The LED arrays 200 to 400 according to the later-described second and third embodiments and modified examples can be used instead of the LED arrays 100 according to the first embodiment.

Fig. 2A shows an example of a projection optical system 51 equipped with at least two LED arrays 100 and at least two projection lenses 105 each of which corresponds to each LED array 100. The projection lenses 105 are positioned to make optical source images 106 of the LED arrays 100 having mirrored electrode patterns overlap with each other on a virtual vertical screen (projection surface) 107 which faces a front of a vehicle. When one LED array 100 has the LED elements 101b, 101a, 101b and 101a horizontally lined up in this order as shown in Fig. 1A and another LED array 100 is a mirror image of that shown in Fig. 1A, i.e., the another LED array 100 has the LED elements 101a, 101b, 101a and 101b horizontally lined up in this order, a projection image of the LED element 101a having a brightness distribution which gradually becomes darker from the top to the bottom and a projection image of the LED element 101b having a brightness distribution which gradually becomes brighter from the top to the bottom are overlapped with each other on the projection surface 107. Therefore, the uneven brightness can be reduced.

Moreover, as shown in Fig. 2B, the projection optical system 51 can be equipped with a multireflector (a reflection surface) 103 to share one projection lens with a plurality of LED arrays 100.

The headlamp 50 shown in Fig. 2B consists of a light source 102 consisting of at least two LED arrays whose electrode patterns are horizontally mirrored and a fluorescent layer (wavelength transformation layer) 100a and a projection optical system 51 consisting of a reflection surface 103 that is a multireflector divided into a plurality of small reflection regions, a shade 104 and a projector lens 105.

As shown in Fig. 2B, the light source 102 is positioned to make its projecting direction (light emitting surface) upward. The reflection surface 103 is a spheroidal reflection surface whose first focal point is set to near the light source 102 and second focal point is set to neat the upper edge of the shade 104, and it is positioned to cover the side and the front of the light source 102 so that light from the light source 102 irradiates to the reflection surface 103.

As shown in Fig. 2B, the reflection surface 103 projects the light source images 106 of the plurality of the LED arrays 100 of the light source 102 to the front of a vehicle and is designed to project the light source images 106 of two LED arrays 100 whose electrode patterns are mirrored horizontally to the same position on the virtual vertical screen (projection surface) 107 which faces the front of the vehicle in order to overlap the images.

The shade 104 is a shading part for shading a portion of reflected light from the reflection surface 103 to from a cutoff line suitable for a headlamp. The shade 104 is disposed between the projection lens 105 and the light source 102 with placing its upper edge near the focal point of the projection lens 105.

The projection lens 105 is positioned on the front of the vehicle and irradiates the reflected light from the reflection surface 103 onto the projection surface 107.

As in the above, by using two LED array 100 whose electrode patterns (brightness distributions) are mirrored horizontally and by designing the headlamp 50 to make their projection images overlap on the projection surface 107, it becomes possible to further reduce the uneven brightness distribution.

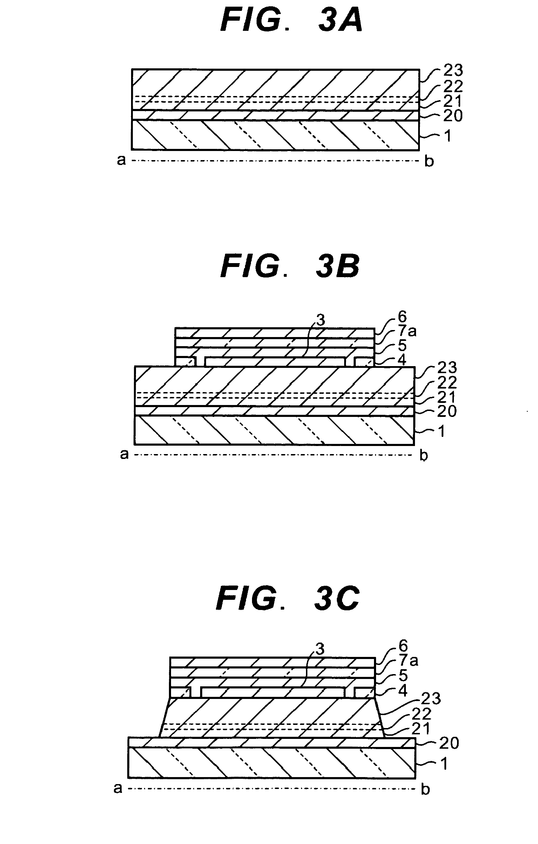

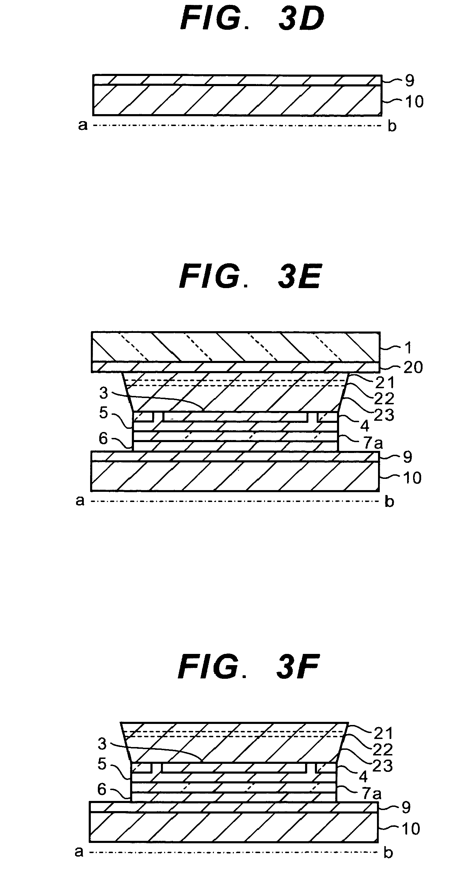

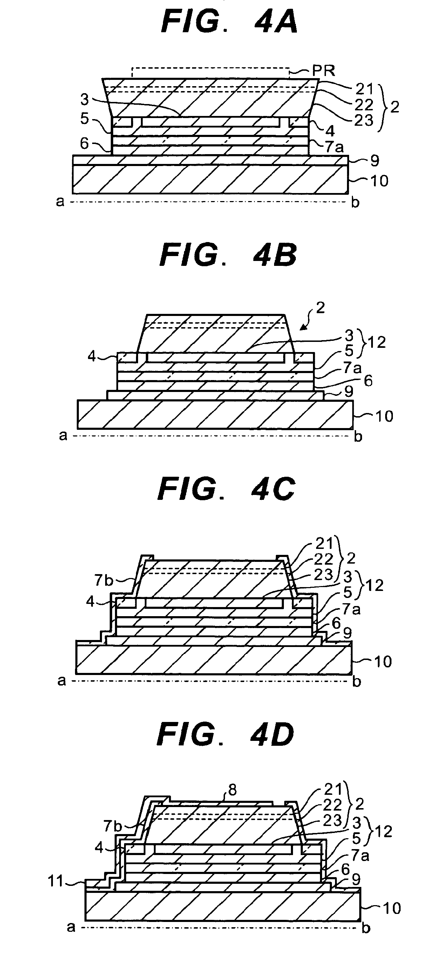

Below describes a method for fabricating the LED array 100 according to the first embodiment of the present invention with reference to Fig. 3 and Fig. 4. Fig. 3 and Fig. 4 are schematic cross sectional view of the nitride semiconductor light emitting element (LED element) 101a cut along the line a-b in Fig. 1. Although only one LED element 101 is depicted in Fig. 3 and Fig. 4, practically at least four of the LED elements 101a and 101b are alternatively arranged on the same substrate. Moreover, the method described below is just an example, and a fabricating method of the LED array 100 is not limited to that. Furthermore, the LED arrays 200-400 according to the later-described second and third embodiments and modified examples can be fabricated by the similar processes.

First, as shown in Fig. 3A, a transparent substrate 1 made of sapphire is prepared, and a device structure layer (GaN-based light emitting part) 2 consisting of nitride semiconductors is formed by using a metal organic chemical vapor deposition (MOCVD) technique. For example, after disposing the sapphire substrate 1 into a MOCVD apparatus, thermal cleaning is performed. Thereafter, GaN buffer layer 20 is grown, and thereon an n-type GaN layer 21 doped with Si or the like with a thickness of about 5µm, a multi-quantum well light emitting layer (active layer) 22 including an InGaN quantum well layer, a p-type GaN layer 23 doped with Mg or the like with a thickness of about 0.5µm are sequentially grown to form the GaN-based light emitting part 2. The sizes of the components shown in the cross sectional views in Fig. 3 and Fig. 4 are modified for convenience of the explanation. The transparent substrate 1 is a monocrystalline substrate with a lattice constant capable of epitaxial growth of GaN and selected from material that is transparent to light with a wavelength of 362nm, which is an absorption edge wavelength of GaN in order to remove the substrate by a laser-lift-off process later on. As the transparent substrate1, spinel, SiC, ZnO or the like can be used instead of the sapphire.

Next, as shown in Fig. 3B, an Ag layer with a thickness of 200nm is formed on a surface of the device structure layer 2 (surface of the p-type GaN layer 23) by the electron beam evaporation technique and patterned by photolithography to form a p-electrode layer (first electrode layer) 3. Thereafter, an etch-stop layer 4 made of SiO₂ with the same thickness as the p-electrode layer 3 is formed by using the sputtering technique. The etch-stop layer 4 functions as an etch stopper in the later-described etching process shown in Fig. 4B.

Then, a diffusion barrier layer 5 made of TiW with a thickness of 300nm is formed in a region including the p-electrode layer 3 and the etch-stop layer 4 by using the sputtering technique. The diffusion barrier layer 5 prevents diffusion of material of the p-electrode layer 3, and Ti, W, Pt, Pd, Mo, Ru, Ir and their alloys can be used for forming the diffusion barrier layer 5 when the p-electrode layer 3 includes Ag. Continuously, an insulating layer 7a made of SiO₂ is formed on the diffusion barrier layer 5 by the sputtering technique or the like, and thereon a first bonding layer 6 made of Au with a thickness of 200nm is formed by using the electron beam evaporation technique.

Next, as shown in Fig. 3C, the device structure layer 2 is divided into a plurality of oblong elements by the dry-etching technique using a resist mask and chlorine gas. Side surfaces of the divided device structure layer 2 are inclined, and the divided device structure layer 2 is in a shape whose areas of horizontal cross sections decrease from the bottom to the top.

Next, as shown in Fig. 3D, a supporting substrate 10 made of Si is prepared, and thereon a second bonding layer 9 made of AuSn (Sn: 20wt%) with a thickness of 1µm is formed by using the resistive heating evaporation. The supporting substrate 10 is preferably made of material having a coefficient of thermal expansion that is close to that of sapphire or GaN and high thermal conductivity. For example, Si, AIN, Mo, W, CuW or the likes can be used for the supporting substrate 10.

The material for the first bonding layer 6 and the second bonding layer 9 can be selected from metals capable of fusion bonding such as metal including Au-Sn, Au-In, Pd-In, Cu-In, Cu-Sn, Ag-Sn, Ag-In, Ni-Sn or the likes and from metals including Au, which is capable of diffusion bonding.

Next, as shown in Fig. 3E, the first bonding layer 6 and the second bonding layer 9 are fusion-bonded by contacting each other, heating them to 300 degrees Celsius under the pressure of 3MPa for ten minutes and then cooling them down to a room temperature.

Thereafter, the buffer layer 20 is decomposed by heating by irradiating a light of an UV Excimer laser to the sapphire substrate 1 from the back, as shown in Fig. 3F, to perform a peeling-off process of the sapphire substrate 1 by the laser lift off technique. The peeling-off or removal of the substrate 1 can be performed by other process such as etching or the likes.

Next, as shown in Fig. 4A, a photoresist PR exposing edges the device structure layer 2 is formed. Then, by the dry-etching technique using chlorine gas, the edges of the device structure layer 2 exposed from the photoresist PR are etched until the ethic-stop layer 4 is exposed. Thus, as shown in Fig. 4B, the side walls of the device structure layer 2 are inclined, and so the shape of the device structure layer 2 becomes a tapered shape whose cross sections decrease upward from the supporting substrate 10.

Next, as shown in Fig. 4C, a protection film (insulating film) 7b made of SiO₂ is formed on all over the upper surface of the element fabricated by the above-described processes by the sputtering technique or the like, and then a portion of the protection film 7b formed on the device structure layer 2 is etched by using buffered hydrogen fluoride to expose a portion of the surface of the device structure layer 2 (surface of the n-type GaN layer 21) exposed by the peeling-off of the transparent substrate 1.

Next, as shown in Fig. 4D, a Ti layer with a thickness of 10nm, an Al layer with a thickness of 300nm and an Au layer with a thickness of 2µm are sequentially formed in this order by using the electron beam evaporation technique and patterned by the lift-off technique to simultaneously form a wiring electrode (first wiring layer) 11 with a width of, for example, about 40µm at a position near the long side of the device structure layer 2 in parallel to that long side and wiring electrodes (second wiring electrodes) 8 with a width of, for example, about 10µm in parallel to the short side and electrically connected to the wiring electrode 11. The width of the wiring electrode 11 is preferably 20µm to 200µm. Moreover, the width of the wiring electrodes 8 is preferably 3µm to 20µm. Furthermore, the width of the wiring electrode 11 is preferably wider than the width of the wiring electrodes 8.

The wiring pattern, width, thickness and material of the wiring electrodes 8 are selected to make an amount of injection current at the periphery of the element is larger than that in the center of the element. In the first embodiment, the wiring electrodes 8 are formed in parallel to the short side of the LED element 101 and perpendicular to the long side of the LED element 101; however, he wiring electrodes 8 are not necessarily formed in parallel to the short side if they are not parallel to the long side.

The wiring electrodes 11 of the adjacent elements are formed near the different long sides. The wiring electrodes 8 are electrically connected to the portion of the surface of the device structure layer 2 (surface of the n-type GaN layer 21) exposed by the above-described processes. The wiring electrodes 8 connected to the n-side (n-type GaN layer 21) are formed on the surface of the n-type GaN layer 21 so that a plane shape of those is a comb shape in which the wiring electrode 11 is a base and the wiring electrodes 8 are teeth as shown in Fig. 1A in order not to decrease the brightness.

The wiring electrode 11 is preferably positioned outside the area of the device structure layer 2 in order not to prevent light extraction from the device structure layer 2. However, if it is positioned too far from the device structure layer 2, wiring resistance in the wiring electrodes 8 becomes high. Therefore, it is preferable to set an interval between the wiring electrode 11 and the long side of the device structure layer 2 within 50µm. The wiring electrode 11 is connected to the p-electrode layer 3 of the adjacent element to form the light emitting array 100 wherein a plurality of the elements are connected in series. In case of fabricating a plurality of the LED arrays 100 from one substrate, the element isolation is performed by braking after scribing.

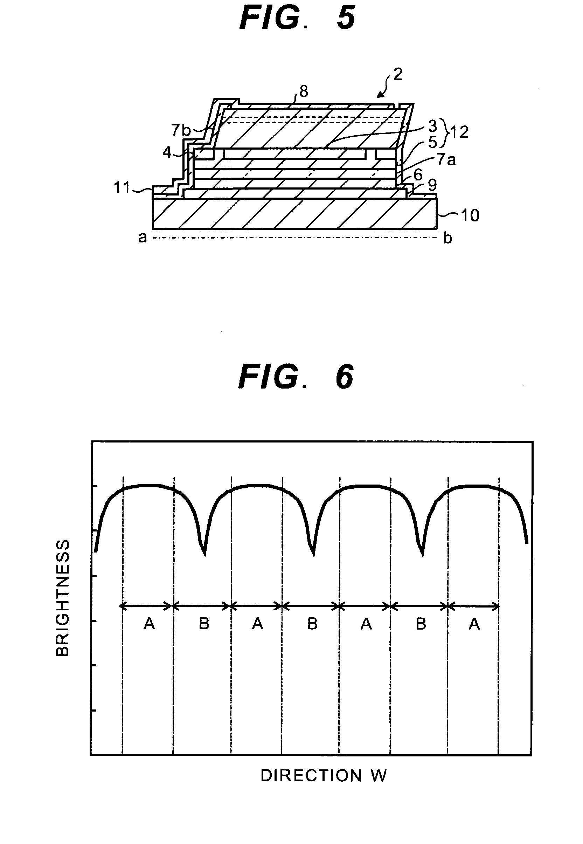

Moreover, the device structure layer 2 may be processed to have only one long sidewall spreading outside toward the bottom as shown in Fig. 5. In this case, the photoresist exposing only one long side of the device structure layer is formed at the photoresist formation process shown in Fig. 4A, and the exposed one long side of the device structure layer 2 is etched to spread outside toward the bottom by the dry-etching technique using chlorine gas at the etching process shown in Fig. 4B. Moreover, the wiring electrodes 8 are formed on the slanted surface of the etched long side. Further, the adjacent LED elements 101 have the slanted surface spreading outside toward the bottom on the different long sides.

Fig. 6 is a graph showing the horizontal brightness distribution of the LED array 100 according to the first embodiment. The vertical axis represents the brightness, and the horizontal axis represents a horizontal position (in the direction W) on the LED array 100.

For the LED array 100 according to the first embodiment, the wiring electrodes 8 are designed to make density of injection current by the wiring electrodes 8 uniform in the horizontal direction on the light emitting surface of the light emitting part 2. That is, a coverage rate of the light emitting surface by the wiring electrodes 8 (formation density or a width of the wiring electrodes 8) and resistance (a thickness or material of the wiring electrodes 8) is the same all over the light emitting surface.

In case of forming the LED array with a plurality of the elements, an interval between the adjacent LED elements 101 is a non-light emitting region, the brightness decreases around the region, and uneven brightness distribution is generated in the LED array 100 as a whole as shown in Fig. 6. Moreover, the light emitting surface of the light emitting part 2 in each LED element 101 has uneven brightness distribution in which the horizontal center has the highest brightness and the brightness lowers toward the periphery (near the interval between the elements). It is considered that the diffusion of light in the semiconductor structure layer 2 relates to the uneven distribution.

When all of the electrode pattern, the width, the thickness and the material of the wiring electrodes 8 are uniformly formed all over the element, the brightness at the edges of the LED element 101 becomes 1/2 to 1/1.2 of the brightness of the center.

In order to make these brightness distributions even, according to the second and the third embodiments of the present invention and modified examples, the coverage rate of the light emitting surface by the wiring electrodes 8 (formation density or a width of the wiring electrodes 8) and resistance (a thickness or material of the wiring electrodes 8) in a region A around the horizontal center of the element (hereinafter called the central region A) are differentiated from those in the region B around the interval between the elements (hereinafter called the peripheral region B) in each LED element so as to reduce the uneven brightness distribution by making the density of injection current in the peripheral region B higher than that in the central region A to make the brightness in the peripheral region B higher than that in the first embodiment. For example, the amount of the injection current in the peripheral region B is designed to be 1.2 to 2 times larger than that in the central region A to compensate the decrease in the brightness in the peripheral region B.

In case of fabricating the LED arrays according to the later-described second and the third embodiments of the present invention and the modified examples, the wiring patterns, the width, the thickness and the material of the wiring electrodes 8 are selected to make the amount of injection current in the peripheral region B higher than that in the central region A in the process shown in Fig. 4D. For example, according to the second embodiment, an electrode pitch Pb in the peripheral region B is made to be narrower than an electrode pitch Pa in the central region A to increase the density of the wiring electrodes 8 in the peripheral region B, and thus the density of the injection current by the wiring electrodes 8 in the peripheral region B becomes higher than that in the central region A.

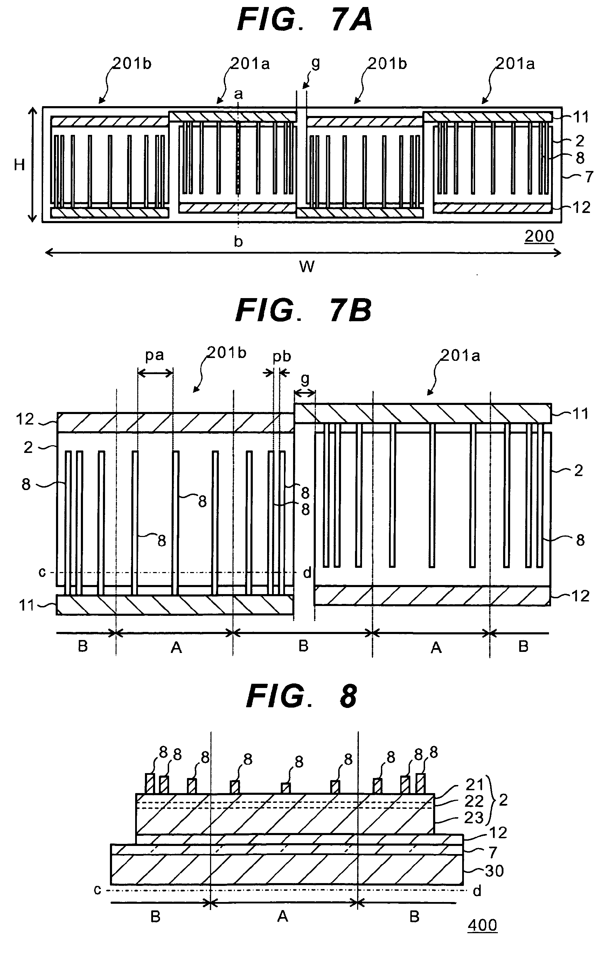

Fig. 7A is a schematic plan view of an LED array 200 according to the second embodiment of the present invention, and Fig. 7B is a schematic plan view of the LED elements 201a and 201b composing the LED array 200. The LED array 200 according to the second embodiment is different from the LED array 100 according to the first embodiment only in the electrode pattern of the wiring electrodes 8, and other components and the fabrication method are the same. Therefore, the electrode pattern of the wiring electrodes 8 according to the second embodiment is explained and explanations for other components are omitted.

In the second embodiment, as shown in Fig. 7A and Fig. 7B, the electrode pitch continuously gets narrower from the electrode pitch Pa in the central region A to the electrode pitch PB in the peripheral region B so as to make the density of the wiring electrodes 8 in the peripheral region B high, and thus the density of the injection current by the wiring electrodes 8 in the peripheral region B becomes higher than that in the central region A. Moreover, the electrode pitch may get narrower stepwise from the electrode pitch Pa in the central region A to the electrode pitch PB in the peripheral region B. That is, according to the second embodiment, the coverage rate of the light emitting surface by the wiring electrodes 8 in the peripheral region B is designed to be higher than that in the central region A. Furthermore, a ratio of the pitch Pa in the central region A to the pitch Pb in the peripheral region B is preferably 1.2:1 to 2:1.

Moreover, it is preferable to form the wiring electrodes 8 with an area proportion (coverage rate) of less than 20% of the surface of the device structure layer 2 in order not to prevent extracting light generated in the device structure layer 2.

As described in the above, by making the density of the injection current by the wiring electrodes 8 in the peripheral region B higher than that in the central region A, the brightness in the peripheral region B can be increased and the uneven brightness distribution can be reduced.

Fig. 8 is a schematic cross sectional view of an LED element 401 according to a first modified example of the second embodiment of the present invention. The LED array 400 according to the first modified example differs from the LED array 200 according to the second embodiment in that the thickness of the wiring electrodes 8 varies in regions, and because other components and its fabrication method are the same, the explanations for those will be omitted. The electrode pattern in a plan view is the same as in the second embodiment so that the modified example will be explained with reference to Fig. 7A and Fig. 7B in addition to Fig. 8.

In this first modified example, in addition to the feature of the second embodiment, the density of the injection current in the periphery region B is increased by making the wiring resistance of the wiring electrodes 8 in the periphery region B lower than that in the central region A.

As shown in Fig. 8, it is designed that the thickness of the wiring electrodes 8 continuously increases from the central region A to the peripheral region B. That is, the thickness of the wiring electrodes 8 in the peripheral region B is made to be wider than that in the central region A to make the wiring resistance of the wiring electrodes 8 in the peripheral region B lower than that in the central region A. Further, a ratio of the thickness of the wiring electrodes 8 in the central region A to that in the peripheral region B is preferably 1:1.2 to 1:2.

The thickness of the wiring electrodes 8 can be increased either continuously or stepwise from the center of the element to the edge of the element (to the short side).

Next, a second modified example of the second embodiment of the present invention will be explained. In the second modified example, the wiring electrodes 8 are disposed by using the same electrode pattern as the second embodiment, and the material of the wiring electrodes 8 varies in regions. Therefore, the second modified example will be explained with reference to Fig. 7A and Fig. 7B.

In the second modified example, the proportion of the resistivity of material composing the wiring electrodes 8 in the central region A to the resistivity of material composing the wiring electrodes 8 in the peripheral region B is set to 1.2:1 to 2:1. For example, Al (resistivity: 2.5×10⁻⁶Ωcm) is used as the main material of the wiring electrodes 8 in the central region A while Au (resistivity: 2.05×10⁻⁶Ωcm) or Cu (resistivity: 1.55×10⁻⁶Ωcm) is used as the main material of the wiring electrodes 8 in the peripheral region B. Moreover, Al or Au may be used as the main material of the wiring electrodes 8 in the central region A while Cu may be used as the main material of the wiring electrodes 8 in the peripheral region B.

Further, the above-described first and second modified examples can be simultaneously adapted to the second embodiment in addition to adopting one by one. Furthermore, both or either one of the above-described first and second modified examples of the second embodiment can be adapted to the first embodiment.

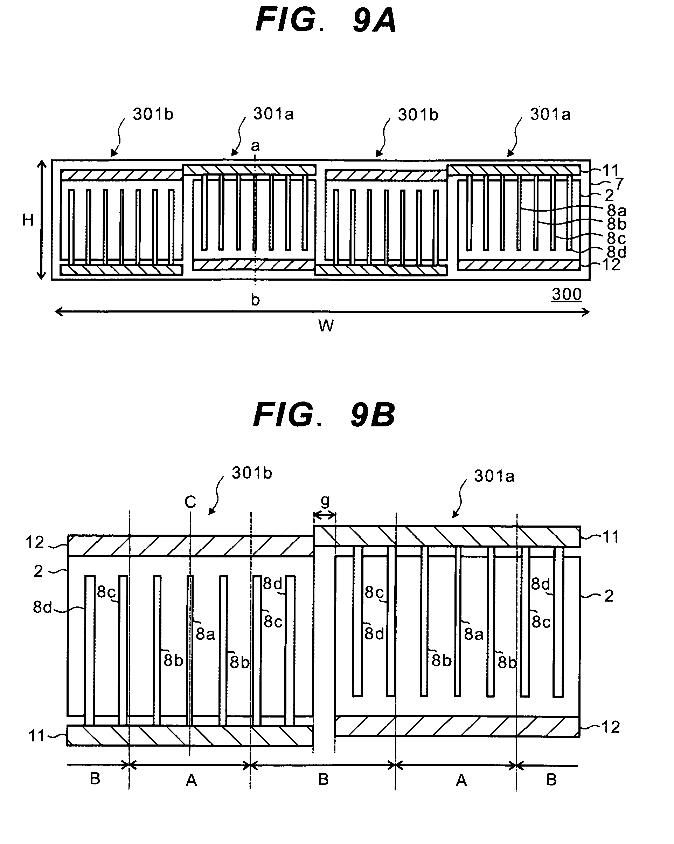

Fig. 9A is a schematic plan view of the LED array 300 according to the third embodiment of the present invention, and Fig. 9B is a schematic plan view of LED elements 301a and 301b composing the LED array 300. The LED array 300 according to the third embodiment is different from the LED array 100 according to the first embodiment and the LED array 200 according to the second embodiment only in the electrode pattern of the wiring electrodes 8, and other components and the fabrication method are the same. Therefore, the electrode pattern of the wiring electrodes 8 according to the third embodiment is explained and explanations for other components are omitted.

In this third embodiment, similarly to the second embodiment, the coverage rate of the light emitting surface by the wiring electrodes 8 in the peripheral region B is designed to be higher than that in the central region A to increase the density of the injection current by the wiring electrodes 8 in the peripheral region B. However, the difference from the first embodiment is that the coverage rate is increased by making the width of the wiring electrodes 8 instead of increasing the density of the wiring electrodes 8.

As shown in Fig. 9A and Fig. 9B, the width of the electrodes continuously increases from the central region A to the peripheral region B to make the widths of the wiring electrodes 8 (8c and 8d) in the peripheral region B wider than the widths of the wiring electrodes 8 (8a and 8b) in the central region A (e.g., 8a≤8b<8c≤8d) so that the density of the injection current by the wiring electrodes 8c and 8d in the peripheral region B becomes higher than the central region A. The proportion of the width of the electrodes in the central region A to the width of the electrodes in the peripheral region B is preferably 1:1.2 to 1:2. Moreover, it is preferable to form the wiring electrodes 8 with an area proportion (coverage rate) of less than 20% of the surface of the device structure layer 2 in order not to prevent extracting light generated in the device structure layer 2. The width of the wiring electrodes 8 can be increased either continuously or stepwise from the center C of the element to the edge of the element (to the short side).

According to the third embodiment, similar to the second embodiment, by making the density of the injection current by the wiring electrodes 8 in the peripheral region B higher than that in the central region A, the brightness in the peripheral region B can be increased and the uneven brightness distribution can be reduced.

Moreover, although pitches of the horizontal centers of the adjacent wiring electrodes 8 are designed to be the same all over the element in this third embodiment, the pitches of the horizontal centers of the adjacent wiring electrodes 8 can be designed to decrease continuously or stepwise from the central region A to the peripheral region B by adopting the second embodiment to the third embodiment.

Further, both or either one of the first and the second modified examples of the second embodiment can be adapted also to the third embodiment. Furthermore, both or either one of the first and the second modified examples of the second embodiment can be adapted also to a combination of the second and the third embodiments.

As described in the above, the embodiments of the present invention utilizes the electrode pattern wherein the wide wiring electrode 11 is disposed along the long side of each LED element 101 in parallel to the long side to diffuse electric current in the direction of the long side, and the narrow wiring electrodes 8 are disposed in parallel to the short side to inject the electric current to the light emitting part 2. Therefore, the wiring resistance of the wiring electrodes 8 can be lowered by reducing the length of the wiring electrodes 8, and the uneven brightness distribution of each LED element 101 can be considerably reduced.

Moreover, the wiring electrodes (the first electrode layers) are disposed on different long sides in the adjacent LED elements. Therefore, the vertical brightness distributions of the adjacent elements are turned upside down, and so the uneven bright ness distribution of the LED array can be reduced.

Further, the wiring electrode 11 is disposed along the long side of each LED element 101, the interval g between the LED elements 101 can be narrowed and thereby the decrease in the brightness in the interval between the LED elements 101 and in the regions around the interval can be restrained.

Furthermore, the uneven brightness in a projection image can be reduced by composing the headlamp 50 with two LED arrays 100 whose electrode patterns (brightness distributions) are turned upside down (mirrored) and whose projection images are projected onto the same position of the projection surface 107 to overlap each other.

Moreover, according to the second and the third embodiments of the present invention, the density of the injection current by the wiring electrodes 8 in the peripheral region B is made to be higher than that in the central region A by making the coverage rate of the wiring electrodes 8 in the peripheral region B higher than that in the central region A; therefore, the brightness in the peripheral region B can be increased and the uneven brightness distribution can be reduced.

Moreover, according to the first and the second modified examples of the second embodiments, the density of the injection current in the periphery region B is increased by making the wiring resistance of the wiring electrodes 8 in the periphery region B lower than that in the central region A; therefore, the brightness in the peripheral region B can be increased and the uneven brightness distribution can be reduced.

Further, the above-described first to third embodiments and the modified examples can be arbitrary combined with other embodiments and modified examples. For example, by combining the second and the third embodiments, the density of the wiring electrodes may be increase from the central region of the element to the peripheral region of the element while the width of the wiring electrodes increases from the central region of the element to the peripheral region of the element. Furthermore, all of the first to third embodiments and the modified examples can be combined at the same time.

The present invention has been described in connection with the preferred embodiments. The invention is not limited only to the above embodiments. It is apparent that various modifications, improvements, combinations, and the like can be made by those skilled in the art.

## Claims

1. A semiconductor light emitting array wherein a plurality of semiconductor light emitting elements are disposed on an oblong substrate that is long in a first direction and the semiconductor light emitting elements are arranged along with the first direction, each one of the light emitting elements comprising:
an electrode layer formed on the substrate;
a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer;
a first wiring layer formed along and in parallel to one long side of the semiconductor light emitting layer; and
second wiring layers extending to a direction of a short side from the first wiring layer and electrically connected to the n-type semiconductor layer on a surface of the semiconductor light emitting layer,
wherein the first wiring layers are disposed on different long sides of the semiconductor light emitting layers in the adjacent light emitting elements.

2. The semiconductor light emitting array according to claim 1, wherein the first wiring layer of one semiconductor light emitting element is electrically connected to the electrode layer of another semiconductor light emitting element adjacent to the one semiconductor light emitting element, and the plurality of semiconductor light emitting elements are connected in series.

3. The semiconductor light emitting array according to claim 1, wherein an amount of an injection current to the semiconductor light emitting layer by the second wiring layer formed around an edge of the semiconductor light emitting layer near the adjacent light emitting element is larger than an amount of an injection current to the semiconductor light emitting layer by the second wiring layer formed around a center of the semiconductor light emitting layer.

4. A semiconductor light emitting array wherein a plurality of semiconductor light emitting elements are disposed on a substrate, each one of the light emitting elements comprising:
an electrode layer formed on the substrate;
a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer;
a first wiring layer formed along and in parallel to one side of the semiconductor light emitting layer; and
second wiring layers extending to the semiconductor light emitting layer from the first wiring layer and electrically connected to the n-type semiconductor layer on a surface of the semiconductor light emitting layer,
wherein an amount of an injection current to the semiconductor light emitting layer by the second wiring layer formed around an edge of the semiconductor light emitting layer near the adjacent light emitting element is larger than an amount of an injection current to the semiconductor light emitting layer by the second wiring layer formed around a center of the semiconductor light emitting layer.

5. The semiconductor light emitting array according to claim 4, wherein an interval between the second wiring layers formed around an edge of the semiconductor light emitting layer near the adjacent light emitting element is narrower than an interval between the second wiring layers formed around a center of the semiconductor light emitting layer.

6. The semiconductor light emitting array according to claim 4, wherein a width of the second wiring layer formed around an edge of the semiconductor light emitting layer near the adjacent light emitting element is wider than a width of the second wiring layer formed around a center of the semiconductor light emitting layer.

7. The semiconductor light emitting array according to claim 4, wherein a thickness of the second wiring layer formed around an edge of the semiconductor light emitting layer near the adjacent light emitting element is thicker than a thickness of the second wiring layer formed around a center of the semiconductor light emitting layer.

8. The semiconductor light emitting array according to claim 4, wherein a resistivity of the second wiring layer formed around an edge of the semiconductor light emitting layer near the adjacent light emitting element is lower than a resistivity of the second wiring layer formed around a center of the semiconductor
light emitting layer.

9. The semiconductor light emitting array according to claim 4, wherein the first wiring layer of one semiconductor light emitting element is electrically connected to the electrode layer of another semiconductor light emitting element adjacent to the one semiconductor light emitting element, and the plurality of semiconductor light emitting elements are connected in series.

10. An automotive lighting, comprising:
at least two semiconductor light emitting arrays, each comprising a plurality of semiconductor light emitting elements disposed on an oblong substrate that is long in a first direction and the semiconductor light emitting elements are arranged along with the first direction, each one of the light emitting elements comprising an electrode layer formed on the substrate, a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer, a first wiring layer formed along and in parallel to one long side of the semiconductor light emitting layer, and second wiring layers extending to a direction of a short side from the first wiring layer and electrically connected to the n-type semiconductor layer on a surface of the semiconductor light emitting layer, wherein the first wiring layers are disposed on different long sides of the semiconductor light emitting layers in the adjacent light emitting elements; and
an optical system that projects projection images of said at least two semiconductor light emitting arrays with overlapping each other on a projection plane,
wherein said at least two semiconductor light emitting arrays are arranged to make brightness distribution of the projection image of one semiconductor light emitting array a mirrored image of brightness distribution of the projection image of another semiconductor light emitting array.

11. An automotive lighting, comprising:
at least two semiconductor light emitting arrays, each comprising a plurality of semiconductor light emitting elements are disposed on a substrate, each one of the light emitting elements comprising an electrode layer formed on the substrate, a semiconductor light emitting layer formed on the electrode layer, stretched long in the first direction and comprising a p-type semiconductor layer electrically connected to the electrode layer, an active layer formed on the p-type semiconductor layer and an n-type semiconductor layer formed on the active layer, a first wiring layer formed along and in parallel to one side of the semiconductor light emitting layer, and second wiring layers extending to the semiconductor light emitting layer from the first wiring layer and electrically connected to the n-type semiconductor layer on a surface of the semiconductor light emitting layer, wherein an amount of an injection current to the semiconductor light emitting layer by the second wiring layer formed around an edge of the semiconductor light emitting layer near the adjacent light emitting element is larger than an amount of an injection current to the semiconductor light emitting layer by the second wiring layer formed around a center of the semiconductor light emitting layer; and
an optical system that projects projection images of said at least two semiconductor light emitting arrays with overlapping each other on a projection plane,
wherein said at least two semiconductor light emitting arrays are arranged to make brightness distribution of the projection image of one semiconductor light emitting array a mirrored image of brightness distribution of the projection image of another semiconductor light emitting array.
